# FASCICULE DE BREVET EUROPEEN

(11) **EP 4 348 701 B1**
(45) Date de publication et mention de la délivrance du brevet: **25.06.2025**
(21) Numéro de dépôt: 22731276.6
(22) Date de dépôt: 25.05.2022
(51) Int. Cl.: H01L 21/18, H01L 21/02

(54) **PROCEDE DE FABRICATION D'UNE STRUCTURE SEMI-CONDUCTRICE COMPRENANT UNE COUCHE UTILE EN CARBURE DE SILICIUM AUX PROPRIETES ELECTRIQUES AMELIOREES**
VERFAHREN ZUR HERSTELLUNG EINER HALBLEITERSTRUKTUR MIT EINER NUTZSCHICHT AUS SILICIUMCARBID MIT VERBESSERTEN ELEKTRISCHEN EIGENSCHAFTEN
METHOD FOR PRODUCING A SEMICONDUCTOR STRUCTURE COMPRISING A USEFUL LAYER MADE OF SILICON CARBIDE, WITH IMPROVED ELECTRICAL PROPERTIES

(30) Priorité: 03.06.2021 FR 2105848
(43) Date de publication de la demande: 10.04.2024
(73) Titulaire: SOITEC, 38190 Bernin (FR); Commissariat à l'Energie Atomique et aux Energies Alternatives, 75015 Paris (FR)
(72) Inventeur: DROUIN, Alexis, 38190 Bernin (FR); GAUDIN, Gweltaz, 38190 Bernin (FR); ROUCHIER, Séverin, 38190 Bernin (FR); SCHWARZENBACH, Walter, 38190 Bernin (FR); WIDIEZ, Julie, 38054 Grenoble Cedex 9 (FR); ROLLAND, Emmanuel, 38054 Grenoble Cedex 9 (FR)
(74) Mandataire: IP Trust
(86) Numéro de dépôt international: PCT/FR2022/051000
(87) Numéro de publication internationale: WO 2022/254131

(56) Documents cités:
- US-A1- 2020 006 046
- US-A1- 2020 006 493
- FU R K Y ET AL: "Investigation of substrate damage and other issues in hydrogen plasma implantation for silicon-on-insulator (SOI) fabrication", 22 October 2001, SOLID-STATE AND INTEGRATED-CIRCUIT TECHNOLOGY, 2001. PROCEEDINGS. 6TH INTERNATIONAL CONFERENCE ON OCT. 22-25, 2001, PISCATAWAY, NJ, USA,IEEE, PAGE(S) 669 - 672, ISBN: 978-0-7803-6520-9, XP010576054

## Description

### DOMAINE DE L'INVENTION

La présente invention concerne le domaine des matériaux semiconducteurs pour composants microélectroniques. Elle concerne en particulier un procédé de fabrication d'une structure semi-conductrice comprenant une couche utile en carbure de silicium monocristallin transférée sur un substrat support en carbure de silicium, via une interface de collage. Le procédé permet d'améliorer les propriétés électriques de la couche utile, ainsi que celles de la structure semi-conductrice lorsqu'une conduction électrique verticale est recherchée.

### ARRIERE PLAN TECHNOLOGIQUE DE L'INVENTION

Il est habituel de former une structure semi-conductrice par report d'une couche utile semi-conductrice, de faible épaisseur et de haute qualité cristalline, sur un substrat support semiconducteur avantageusement de plus faible qualité cristalline. Une solution de transfert de couche mince bien connue est le procédé Smart Cut^{®}, basé sur une implantation d'espèces légères et sur un assemblage par adhésion moléculaire au niveau d'une interface de collage. Les espèces légères sont classiquement choisies parmi les ions hydrogène, hélium ou une combinaison de ces deux espèces. Le collage direct par adhésion moléculaire peut être obtenu par différentes approches, à température ambiante ou en température, sous atmosphère ambiante ou contrôlée, notamment sous vide, en appliquant une pression sur les substrats après mise en contact intime de leurs faces à assembler ou par simple initiation ponctuelle d'une onde de collage lorsque les faces à assembler sont disposées en vis-à-vis. Les différentes approches de collage direct peuvent également se distinguer par le traitement de préparation des surfaces à assembler, opéré juste avant l'assemblage. Des nettoyages chimiques secs ou humides, des activations de surface par plasma ou par bombardement atomique (par exemple, SAB pour « Surface Activation Bonding », ADB pour « Atomic Diffusion Bonding », etc), des lissages mécaniques ou mécano-chimiques des surfaces ou encore des dépôts de couches additionnelles favorables au collage, peuvent être appliqués à l'un ou aux deux substrats à assembler.

Après transfert de la couche utile sur le substrat support, il est également habituel d'appliquer un recuit à hautes, voire à très hautes températures, à la structure semi-conductrice, de manière à restaurer les qualités structurelles et électriques de la couche utile et de l'interface de collage. Il est aussi connu de réaliser des traitements de lissage thermiques ou basés sur du polissage mécano-chimique, pour obtenir une faible rugosité de surface au niveau de la face libre de la couche utile transférée, laquelle est destinée à accueillir des composants microélectroniques.

Dans le domaine de l'électronique de puissance notamment, une excellente conductivité électrique de la couche utile est attendue. Il peut en outre être avantageux de former une structure semi-conductrice garantissant une bonne conduction électrique entre la couche utile et la substrat support, de manière à autoriser l'élaboration de composants verticaux.

Par exemple, dans le cas d'une structure semi-conductrice comprenant une couche utile en carbure de silicium monocristallin et un substrat support en carbure de silicium de moindre qualité (monocristallin ou poly-cristallin), il est attendu que les caractéristiques électriques de la couche utile suivent une loi ohmique, la résistivité de ladite couche étant définie par son niveau de dopage. Pour être compatible avec des composants verticaux, il est également attendu que la conduction électrique verticale, c'est-à-dire impliquant la traversée de l'interface de collage, soit fonctionnelle : à savoir, une résistivité de l'interface de collage aussi faible que possible, préférentiellement inférieure à 1 mohm.cm², voire inférieure à 0,1 mohm.cm², et une caractéristique I(V) (courant en fonction de la tension) de type ohmique.

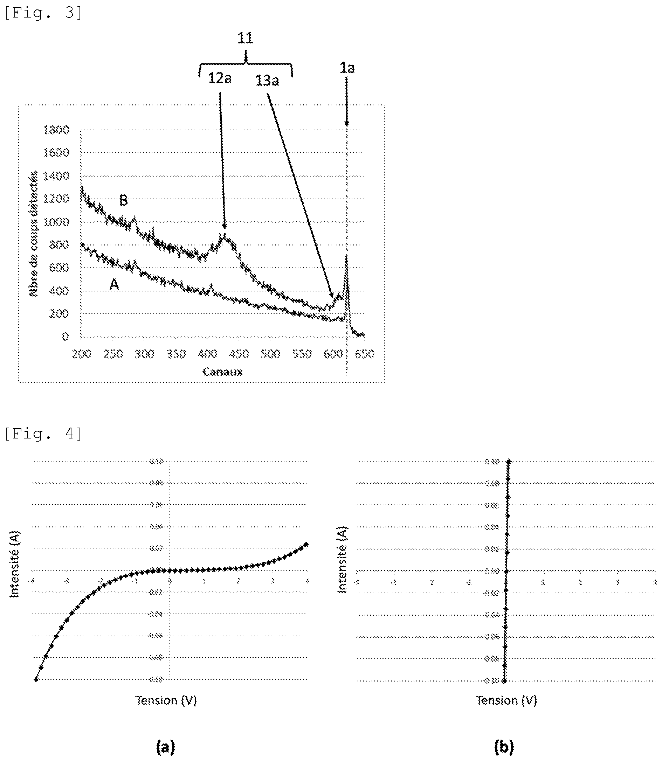

Le transfert d'une couche utile en carbure de silicium monocristallin, sur un substrat support également en carbure de silicium monocristallin, via une couche intermédiaire métallique, par le procédé Smart Cut^{®} avec un recuit final de restauration, appliqué à la structure semi-conductrice, effectué dans la gamme de températures 1300°C - 1700°C, n'est pas suffisant pour obtenir les caractéristiques électriques précédemment énoncées, comme cela apparaît sur la figure 4(a) : la courbe I(V), représentative des propriétés électriques de la couche utile et de la conduction électrique verticale (à travers l'interface de collage) de la structure semi-conductrice ne répondent pas à l'objectif de comportement ohmique.

Bien sûr, un recuit à plus hautes températures, typiquement supérieur à 1800°C, pourrait partiellement améliorer les caractéristiques électriques de la couche utile et de la structure semi-conductrice, mais un tel traitement est particulièrement contraignant à mettre en œuvre et peut en outre provoquer d'autres types de défauts cristallins défavorables, notamment des marches atomiques en surface (« step bunching » selon la terminologie anglo-saxonne), qui requièrent des étapes supplémentaires de protection de la surface, pour éviter l'apparition de ces défauts, ou de traitement de la surface a posteriori, pour les éliminer.

US 2020 006493 A1 divulgue un procédé de fabrication d'une structure semi-conductrice comprenant une couche utile en carbure de silicium monocristallin transférée sur un substrat support en carbure de silicium, via une interface de collage.

### OBJET DE L'INVENTION

La présente invention vise à remédier à tout ou partie des inconvénients précités. Elle concerne en particulier un procédé de fabrication d'une structure semi-conductrice dont la couche utile en carbure de silicium monocristallin, transférée sur un substrat support en carbure de silicium, via une interface de collage, présente d'excellentes propriétés électriques. Le procédé selon l'invention permet en outre d'améliorer les performances de conduction verticale de la structure semi-conductrice, tout en proposant des étapes simples de mise en œuvre.

### BREVE DESCRIPTION DE L'INVENTION

L'invention concerne un procédé de fabrication d'une structure semi-conductrice comprenant les étapes suivantes :
a) la fourniture d'un substrat donneur en carbure de silicium monocristallin et d'un substrat support en carbure de silicium,
b) la préparation d'une couche utile à transférer, comprenant :
   - l'implantation d'espèces légères dans le substrat donneur au niveau d'une face avant, pour former un profil d'endommagement, notamment mesurable par spectroscopie de rétrodiffusion de Rutherford, ledit profil présentant un pic principal de défauts en profondeur définissant un plan fragile enterré et un pic secondaire de défauts définissant une couche endommagée superficielle,
   - le retrait de la couche endommagée superficielle par gravure chimique et/ou par polissage mécano-chimique de la face avant du substrat donneur, pour former une nouvelle surface avant du substrat donneur,
   le plan fragile enterré délimitant, avec la surface avant du substrat donneur, la couche utile à transférer, laquelle présente une épaisseur comprise entre 50 nm et 1400 nm,
c) l'assemblage par adhésion moléculaire du substrat donneur, du côté de la surface avant, et du substrat support, pour former un ensemble collé le long d'une interface de collage ;
d) la séparation le long du plan fragile enterré, menant au transfert de la couche utile sur le substrat support, pour former la structure semi-conductrice.

Selon d'autres caractéristiques avantageuses et non limitatives de l'invention, prises seules ou selon toute combinaison techniquement réalisable :
- le retrait de l'étape b) se traduit par un enlèvement compris entre 5nm et 200nm, préférentiellement compris entre 30nm et 50nm ;
- le matériau du substrat support est monocristallin ou poly-cristallin ;
- les espèces légères sont des ions d'hydrogène, implantés avec une énergie comprise entre 30keV et 210keV et avec une dose comprise entre 1x1016/cm² et 5x1017/cm² ;
- le procédé de fabrication comprend une étape e) de finition appliquée à la structure semi-conductrice issue de l'étape d), l'étape e) impliquant un traitement thermique à une température comprise entre 1300°C et 1700°C ;
- l'étape e) comprend un traitement de lissage mécano-chimique d'une surface libre de la couche utile ;
- l'étape c) comprend la formation d'au moins une couche additionnelle sur la surface avant du substrat donneur et/ou sur une face avant du substrat support, préalablement à l'assemblage par adhésion moléculaire ; et l'ensemble collé, obtenu après l'assemblage par adhésion moléculaire, comprend la couche additionnelle entre le substrat donneur et le substrat support, adjacente à l'interface de collage ou incluant cette dernière ;
- la -au moins une- couche additionnelle comprend un matériau choisi parmi le silicium, le tungstène, le carbone, le titane ;
- le procédé comprend en outre des étapes d'élaboration d'au moins un composant microélectronique à haute tension sur la structure semi-conductrice.

### BREVE DESCRIPTION DES FIGURES

D'autres caractéristiques et avantages de l'invention ressortiront de la description détaillée qui va suivre en référence aux figures annexées :
- La figure 1 présente une structure semi-conductrice élaborée selon un procédé de fabrication conforme à l'invention ;
- Les figures 2a, 2b, 2b', 2c, 2d et 2e présentent des étapes d'un procédé de fabrication conforme à l'invention ;
- La figure 3 présente des mesures par spectroscopie de rétrodiffusion de Rutherford (RBS), respectivement d'un substrat donneur vierge et d'un substrat donneur ayant subi l'implantation d'espèces légères de l'étape b) du procédé de fabrication conformément à l'invention ;
- La figure 4 présente des courbes I(V) du courant en fonction de la tension appliquée, mesurée à partir de deux électrodes élaborées sur une structure semi-conductrice, le chemin de courant traversant l'interface de collage de ladite structure : (a) pour une structure semi-conductrice de l'état de la technique, (b) pour une structure semi-conductrice conforme à l'invention ;
- La figure 5 présente (a) une image par microscopie électronique en transmission (TEM) d'une structure semi-conductrice finale non conforme à l'invention, et (b) une image obtenue par mesure de résistance SSRM d'une structure semi-conductrice finale non conforme à l'invention.

Les mêmes références sur les figures pourront être utilisées pour des éléments de même type. Les figures comportent des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y, et les épaisseurs relatives des couches entre elles ne sont pas respectées sur les figures schématiques.

Les différentes possibilités (variantes et modes de réalisation illustrés et/ou détaillés dans la description à suivre) doivent être comprises comme n'étant pas exclusives les unes des autres et peuvent se combiner entre elles.

### DESCRIPTION DETAILLEE DE L'INVENTION

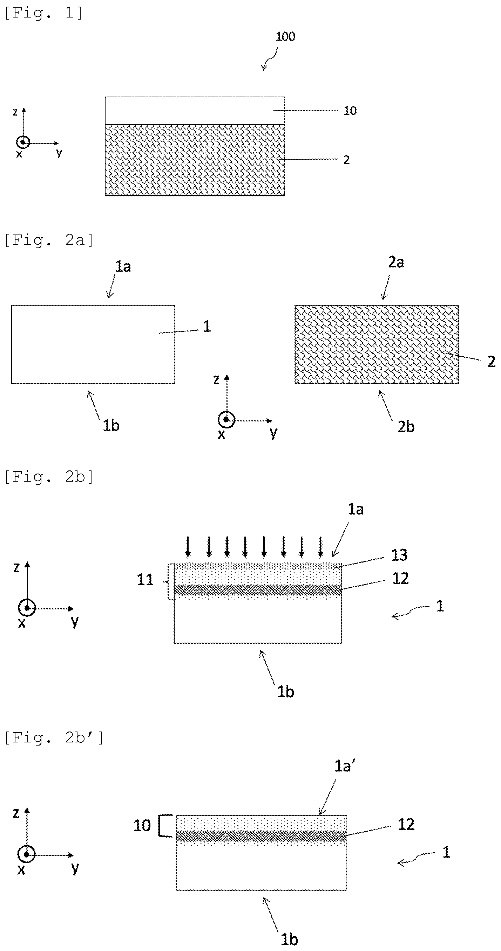

L'invention concerne un procédé de fabrication d'une structure semi-conductrice 100 comprenant une couche utile 10 en carbure de silicium (SiC) monocristallin transférée sur un substrat support 2 (figure 1). Le substrat support 2 peut être formé en carbure de silicium monocristallin ou poly-cristallin.

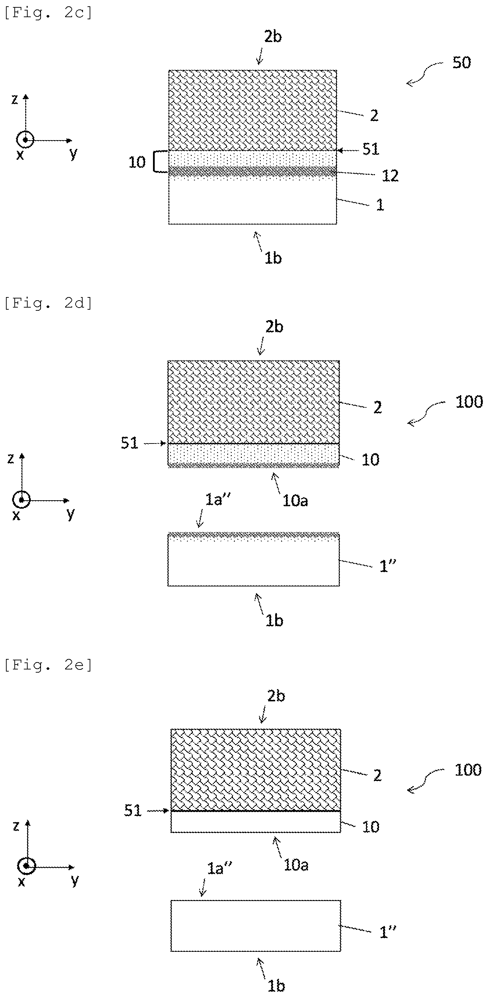

Le procédé de fabrication comprend en premier lieu une étape a) de fourniture d'un substrat donneur 1 en carbure de silicium monocristallin et d'un substrat support 2 en carbure de silicium, monocristallin ou poly-cristallin (figure 2a). Ces deux substrats initiaux 1,2 se présentent préférentiellement sous la forme de plaquettes (dans le plan (x,y)) de diamètre 100mm, 150mm ou 200mm, et d'épaisseur (selon l'axe z) comprise typiquement entre 300 et 800 microns. Ils présentent chacun une face avant 1a,2a et une face arrière 1b,2b. La rugosité de surface des faces avant 1a,2a est avantageusement choisie inférieure à 1 nm RMS mesurée par microscopie à force atomique (AFM) sur un scan de 20 microns x 20 microns.

Le substrat donneur 1 peut, par exemple, être de polytype 4H ou 6H, et présenter un dopage de type n ou p. Dans la suite du procédé, la couche utile 10 de la structure semi-conductrice 100 sera prélevée du substrat donneur 1 : ce dernier doit donc présenter les propriétés mécaniques, électriques et cristallographiques requises pour l'application visée.

Selon un mode de réalisation particulier, le substrat donneur 1 comprend un substrat initial sur lequel une couche donneuse a été réalisée par épitaxie. L'étape de croissance épitaxiale est effectuée de sorte que la couche donneuse présente une densité de défauts cristallins inférieure à celle du substrat initial. Comme la couche utile 10 est, dans ce cas, prélevée dans la couche donneuse, le substrat initial ne nécessite pas un niveau de qualité aussi élevé que la couche donneuse.

Le substrat support 2 doit répondre aux spécifications de tenue mécanique et potentiellement aux spécifications de propriétés électriques autorisant une bonne conduction électrique verticale pour le fonctionnement de composants verticaux de puissance élaborés sur et dans la structure semi-conductrice 100 finale.

Le procédé de fabrication comprend ensuite une étape b) consistant en la préparation de la couche utile 10 à transférer. Cette étape comporte d'abord une implantation d'espèces légères dans le substrat donneur 1 (ou dans la couche donneuse, lorsque celle-ci est présente) au niveau de la face avant 1a, pour former un profil d'implantation des espèces légères et un profil d'endommagement 11 (figure 2b). Ces deux profils sont quasiment superposés, le premier correspond à la concentration en profondeur des espèces implantées, l'autre correspond aux défauts générés dans le réseau cristallin du matériau SiC du substrat donneur 1 lors de la pénétration des espèces.

Le profil d'endommagement 11 est notamment mesurable par spectroscopie de rétrodiffusion de Rutherford (ou RBS). Comme cela est bien connu, la RBS est utilisée pour déterminer la structure et la composition d'un matériau par l'analyse de la rétrodiffusion d'un faisceau d'ions à haute énergie frappant ledit matériau. Elle permet ici de mettre en évidence des zones de défauts présents dans le réseau cristallin SiC implanté du substrat donneur 1.

La courbe A en figure 3 correspond à une mesure par RBS du substrat donneur 1 avant l'implantation d'espèces légères : le profil RBS est plat (à l'exception du pic très étroit détecté au niveau de la face avant 1a qui apparait sur tous les échantillons mesurés et qui n'est donc pas discriminant).

La courbe B de la figure 3 correspond à une mesure par RBS du substrat donneur 1 après l'implantation d'espèces légères. Le profil d'endommagement 11 présente un pic principal 12a de défauts en profondeur (qui est sensiblement superposé au pic de concentration des espèces légères implantées), définissant un plan fragile enterré 12. Le profil d'endommagement 11 présente également un pic secondaire 13a de défauts définissant une couche endommagée superficielle 13.

Les espèces légères implantées sont préférentiellement de l'hydrogène, de l'hélium ou une co-implantation de ces deux espèces. En référence au procédé Smart Cut^{®}, énoncé en introduction, ces espèces légères vont former, au niveau et/ou à proximité du pic principal 12a, des microcavités distribuées dans une fine couche parallèle à la face avant 1a du substrat donneur 1, soit parallèle au plan (x,y) sur les figures. On appelle cette fine couche le plan fragile enterré 12, par souci de simplification.

L'énergie d'implantation des espèces légères est choisie de manière à atteindre une profondeur déterminée dans le substrat donneur 1. Typiquement, des ions hydrogène sont implantés à une énergie comprise entre 30 keV et 210 keV, et à une dose comprise entre 1x1016/cm² et 5x10¹⁷/cm², pour former un plan fragile enterré 12 à une profondeur comprise entre 100nm à 1500nm.

Le pic secondaire 13a, visible sur la figure 3, s'étend de la face avant 1a du substrat donneur 1 jusqu'à une profondeur variable, comprise entre 10 nm et 100 nm, essentiellement fonction des conditions d'implantation (énergie, dose, température...). Cette couche endommagée superficielle 13 peut notamment comprendre des défauts cristallins ponctuels, des défauts étendus (dislocations, etc), ou des espèces non intentionnellement introduites, autres que les espèces légères implantées. La rugosité de surface du substrat donneur 1, au niveau de la face avant 1a ayant subi l'implantation, n'est pas affectée et reste sensiblement similaire à la rugosité initiale, typiquement inférieure à 1 nm RMS.

Après l'implantation ionique des espèces légères, l'étape b) de préparation de la couche utile 10 comporte le retrait de la couche endommagée superficielle 13 par gravure chimique et/ou par polissage mécano-chimique de la face avant 1a du substrat donneur 1 (figure 2b').

La gravure chimique est avantageusement réalisée par voie sèche, par exemple par une gravure ionique réactive à base de gaz O2/SF6/Ar/F. Le polissage mécano-chimique peut être opéré en utilisant des solutions de polissage (« slurry » selon la terminologie anglo-saxonne) avec nano-abrasifs à base d'alumine ou de diamant, et des tissus classiques de type mousse thermoplastique ou polyuréthane.

Quelle que soit la technique mise en œuvre, le retrait opéré à l'étape b) se traduit par un enlèvement de SiC compris entre 5nm et 200nm, préférentiellement compris entre 20nm et 100nm, et encore préférentiellement compris entre 30nm et 50nm. Après cet enlèvement de matière, une nouvelle surface avant 1a' du substrat donneur 1 est formée.

Il est visé de retirer toute la couche endommagée superficielle 13, tout en conservant une bonne uniformité de la couche utile 10 à transférer : en effet, ladite couche utile 10 est délimitée par le plan fragile enterré 12 et la surface avant 1a' du substrat donneur 1, après enlèvement. Une non-uniformité inférieure à +/- 20% de l'épaisseur de la couche utile 10 est visée. La couche utile 10 à transférer présente typiquement une épaisseur comprise entre 50 nm et 1400 nm.

Le procédé de fabrication comprend ensuite une étape c) incluant l'assemblage par adhésion moléculaire du substrat donneur 1, du côté de la surface avant 1a', et du substrat support 2, du côté de sa face avant 2a, pour former un ensemble collé 50 le long d'une interface de collage 51 (figure 2c).

Comme cela est bien connu en soi, le collage direct par adhésion moléculaire ne nécessite pas une matière adhésive, des liaisons s'établissant à l'échelle atomique entre les surfaces assemblées. Plusieurs types de collage par adhésion moléculaire existent, qui diffèrent notamment par les conditions de température, de pression, d'atmosphère ou de traitements préalables à la mise en contact des surfaces. On peut citer le collage à température ambiante avec ou sans activation préalable par plasma des surfaces à assembler, le collage par diffusion atomique (« Atomic diffusion bonding » ou ADB selon la terminologie anglo-saxonne), le collage avec activation de surface (« Surface-activated bonding » ou SAB), etc.

L'étape c) d'assemblage peut comprendre, préalablement à la mise en contact des faces à assembler, des séquences classiques de nettoyages par voie chimique (par exemple, nettoyage RCA), d'activation de surface (par exemple, par plasma oxygène ou azote) ou autres préparations de surface (telles que le nettoyage par brossage (« scrubbing »)), susceptibles de favoriser la qualité de l'interface de collage 51 (faible défectivité, forte énergie d'adhésion).

Selon un premier mode de réalisation, l'assemblage est opéré directement entre la surface avant 1a' du substrat donneur 1 et la face avant 2a du substrat support 2, comme cela est illustré sur la figure 2c.

Selon un deuxième mode de réalisation, l'étape c) comprend la formation d'au moins une couche additionnelle (non représentée) sur la surface avant 1a' du substrat donneur 1 et/ou sur la face avant 2a du substrat support 2, préalablement à l'assemblage par adhésion moléculaire. La -au moins une- couche additionnelle peut comprendre un matériau tel que le silicium, le tungstène, le carbone ou le titane, avantageusement choisi pour favoriser la conduction électrique verticale dans la structure semi-conductrice 100 finale. La couche intermédiaire est en outre susceptible de favoriser le collage par adhésion moléculaire, notamment en gommant une rugosité résiduelle ou des défauts de surface présents sur les faces à assembler. Elle pourra subir des traitements classiques de planarisation ou de lissage, pour atteindre une rugosité inférieure à 1nm RMS, voire inférieure à 0,5nm RMS, favorable au collage ; elle pourra également subir des traitements de préparation tels qu'évoqués précédemment (nettoyage, activation, etc). L'épaisseur de la couche additionnelle est préférentiellement choisie entre 0.5 nm et 50 nm.

Le procédé de fabrication selon l'invention comprend enfin une étape d) de séparation le long du plan fragile enterré 12, menant au transfert de la couche utile 10 sur le substrat support 2, pour former la structure semi-conductrice 100 (figure 2d).

La séparation le long du plan fragile enterré 12 s'opère habituellement par l'application d'un traitement thermique à une température comprise entre 800°C et 1200°C. Un tel traitement thermique induit le développement des cavités et microfissures dans le plan fragile enterré 12, et leur mise sous pression par les espèces légères présentes sous forme gazeuse, jusqu'à la propagation d'une fracture le long dudit plan fragile 12. Alternativement ou conjointement, une sollicitation mécanique peut être appliquée à l'ensemble collé 50 et en particulier au niveau du plan fragile enterré 12, de manière à propager ou aider à propager mécaniquement la fracture menant à la séparation. A l'issue de cette séparation, on obtient d'une part la structure semi-conductrice 100 comprenant le substrat support 2 et la couche utile 3 transférée en SiC monocristallin, et d'autre part, le reste 1'' du substrat donneur. Le niveau et le type de dopage de la couche utile 10 sont définis par le choix des propriétés du substrat donneur 1 ou peuvent être ajustés ultérieurement via les techniques connues de dopage de couches semi-conductrices.

La surface libre 10a de la couche utile 10 est habituellement rugueuse après séparation : par exemple, elle présente une rugosité comprise entre 5nm et 100nm RMS (AFM, scan 20 microns x 20 microns). Des étapes de nettoyage et/ou de lissage peuvent être appliquées pour restaurer un bon état de surface (typiquement, une rugosité inférieure à quelques angströms RMS sur un scan de 20 microns x 20 microns par AFM).

C'est notamment l'objet de l'étape e) de finition, préférentiellement incluse dans le procédé de fabrication selon l'invention. Cette étape, appliquée à la structure semi-conductrice 100 issue de l'étape d), peut comprendre un traitement de lissage mécano-chimique (CMP) de la surface libre 10a de la couche utile 10. Un enlèvement compris entre 50 nm et 300 nm permet de restaurer efficacement l'état de surface de ladite couche 10.

L'étape e) peut également comprendre un traitement thermique à une température comprise entre 1300°C et 1700°C. Un tel traitement thermique est appliqué pour évacuer les espèces légères résiduelles de la couche utile 10 et pour favoriser le réarrangement du réseau cristallin de la couche utile 10.

Comme évoqué en introduction, de bonnes caractéristiques électriques de la couche utile 10, classiquement transférée par implantation d'espèces légères, sont difficilement obtenues si le traitement thermique de finition reste à une température inférieure à 1800°C. Dans l'exemple de la figure 4 (a), la structure semi-conductrice non conforme à l'invention, est formée d'une couche utile en SiC monocristallin (résistivité typique d'environ 20 mohm.cm) transférée sur un substrat support (résistivité typique d'environ 50 mohm.cm) via une couche additionnelle métallique ; les conditions d'implantation dans le substrat donneur étaient les suivantes 130keV, 6*10¹⁶ H/cm², et un traitement thermique de finition a été effectué à 1700°C pendant 1h. On constate que le comportement I(V) de cette structure n'est pas ohmique.

Dans le procédé selon l'invention, ce traitement thermique peut être opéré à une température inférieure ou égale à 1700°C, voire comprise entre 1400°C et 1500°C. On observe effectivement sur la courbe I(V) en figure 4(b), un comportement parfaitement ohmique de la couche utile 10 et de l'interface de collage 51 de la structure semi-conductrice 100 élaborée conformément à la présente invention. Cette dernière est formée d'une couche utile 10 en SiC monocristallin (résistivité typique d'environ 20 mohm.cm) transférée sur un substrat support 2 (résistivité typique d'environ 20 mohm.cm) via une couche additionnelle métallique (empilement comparable à la structure selon l'état de la technique, précitée en référence à la figure 4(a)) ; les conditions d'implantation (étape b) dans le substrat donneur 1 étaient 130keV, 6*10¹⁶ H/cm², le retrait (étape b) de la couche endommagée superficielle 13 a consisté en un enlèvement par CMP de 50nm et le traitement thermique de l'étape e) a été effectué à 1700°C pendant 1h.

Notons qu'un recuit jusqu'à 1900°C pourrait évidemment être réalisé mais ces très hautes températures ne sont pas nécessaires à la restauration des qualités électriques de la couche mince 10 dans le procédé conforme à l'invention.

La demanderesse a identifié que le retrait de la couche endommagée superficielle 13, générée lors de l'implantation ionique de l'étape b) de préparation de la couche utile 10 à transférer du substrat donneur 1, était critique pour l'obtention, après transfert, d'excellentes propriétés électriques de la couche mince 10 et de la structure semi-conductrice 100 en général, en demeurant à des températures de traitements thermiques de finition raisonnables.

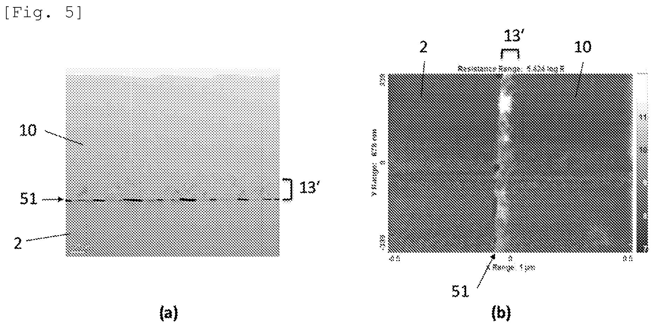

Cette couche endommagée superficielle 13, si elle n'est pas retirée lors de l'étape b) du procédé selon l'invention, est responsable de défauts résiduels 13' dans la couche mince de la structure semi-conductrice finale, comme cela est illustré sur la figure 5(a) : on observe sur cette image par microscopie électronique en transmission (TEM), lesdits défauts résiduels 13', qui demeurent présents malgré des traitements thermiques à hautes températures, jusqu'à 1700°C, voire même jusqu'à 1900°C. On observe également sur la figure 5(b) une mesure par SSRM (« scanning spreading resistance microscopy »), technique de mesure de résistance par balayage d'une pointe de microscope à force atomique, qui montre une zone de résistivité plus importante près de l'interface de collage 51 de la structure semi-conductrice, corrélée avec la zone des défauts résiduels 13'. Les défauts résiduels 13' qui sont présents dans la couche utile 10, près de l'interface de collage 51, lorsque la couche endommagée superficielle 13 n'est pas retirée avant assemblage, sont à l'origine du comportement électrique non ohmique de la structure semi-conductrice que l'on observe sur la figure 4(a). Le procédé de fabrication conforme à l'invention prévoit de retirer la couche endommagée superficielle 13, générée par l'implantation d'espèces légères dans le substrat donneur 1, et assure ainsi la haute qualité de la couche utile 10 dans la structure semi-conductrice 100 finale et son comportement électrique de type ohmique.

Le procédé de fabrication comprend également l'élaboration d' un (ou plusieurs) composant(s) microélectronique(s) à haute tension, tels que par exemple des diodes Schottky, des transistors MOSFET, etc, sur et/ou dans la structure semi-conductrice 100 Des étapes classiques d'élaboration de composants pourront être mises en œuvre, la structure semi-conductrice 100 étant parfaitement compatible avec les techniques et lignes microélectroniques.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Procédé de fabrication d'une structure semi-conductrice (100) comprenant les étapes suivantes :
**a)** la fourniture d'un substrat donneur (1) en carbure de silicium monocristallin et d'un substrat support (2) en carbure de silicium,
**b)** la préparation d'une couche utile à transférer, comprenant :
- l'implantation d'espèces légères dans le substrat donneur (1) au niveau d'une face avant (1a), pour former un profil d'endommagement (11), notamment mesurable par spectroscopie de rétrodiffusion de Rutherford, ledit profil présentant un pic principal (12a) de défauts en profondeur définissant un plan fragile enterré (12) et un pic secondaire (13a) de défauts définissant une couche endommagée superficielle (13),
- le retrait de la couche endommagée superficielle (13) par gravure chimique et/ou par polissage mécano-chimique de la face avant (1a) du substrat donneur (1), pour former une nouvelle surface avant (1a') du substrat donneur (1),
le plan fragile enterré (12) délimitant, avec la surface avant (1a') du substrat donneur (1), la couche utile (10) à transférer, laquelle présente une épaisseur comprise entre 50 nm et 1400 nm,
**c)** l'assemblage par adhésion moléculaire du substrat donneur (1), du côté de la surface avant (1a'), et du substrat support (2), pour former un ensemble collé (50) le long d'une interface de collage (51) ;
**d)** la séparation le long du plan fragile enterré (12), menant au transfert de la couche utile (10) sur le substrat support (2), pour former la structure semi-conductrice (100).

2. Procédé de fabrication selon la revendication précédente, dans lequel le retrait de l'étape b) se traduit par un enlèvement compris entre 5nm et 200nm, préférentiellement compris entre 30nm et 50nm.

3. Procédé de fabrication selon l'une des revendications précédentes, dans lequel le matériau du substrat support (2) est monocristallin ou poly-cristallin.

4. Procédé de fabrication selon l'une des revendications précédentes, dans lequel les espèces légères sont des ions d'hydrogène, implantés avec une énergie comprise entre 30keV et 210keV et avec une dose comprise entre 1x1016/cm² et 5x10¹⁷/cm².

5. Procédé de fabrication selon l'une des revendications précédentes, comprenant une étape e) de finition appliquée à la structure semi-conductrice (100) issue de l'étape d), l'étape e) impliquant un traitement thermique à une température comprise entre 1300°C et 1700°C.

6. Procédé de fabrication selon la revendication précédente, dans lequel l'étape e) comprend un traitement de lissage mécano-chimique d'une surface libre (10a) de la couche utile (10).

7. Procédé de fabrication selon l'une des revendications précédentes, dans lequel :
- l'étape c) comprend la formation d'au moins une couche additionnelle sur la surface avant (1a') du substrat donneur (1) et/ou sur une face avant (2a) du substrat support (2), préalablement à l'assemblage par adhésion moléculaire ; et
- l'ensemble collé (50), obtenu après l'assemblage par adhésion moléculaire, comprend la couche additionnelle entre le substrat donneur (1) et le substrat support (2), adjacente à l'interface de collage (51) ou incluant cette dernière.

8. Procédé de fabrication selon la revendication précédente, dans lequel la -au moins une- couche additionnelle comprend un matériau choisi parmi le silicium, le tungstène, le carbone, le titane.

9. Procédé de fabrication selon l'une des revendications précédentes comprenant en outre des étapes d'élaboration d'au moins un composant microélectronique à haute tension sur la structure semi-conductrice (100).

## Patentansprüche

1. Verfahren zur Herstellung einer Halbleiterstruktur (100), umfassend die folgenden Schritte:
**a)** die Bereitstellung eines Donorsubstrats (1) aus monokristallinem Siliziumkarbid und eines Trägersubstrats (2) aus Siliziumkarbid,
**b)** die Vorbereitung einer zu übertragenden Nutzschicht, umfassend:
- das Einbringen von leichten Spezies in das Donorsubstrat (1) an einer Vorderseite (1a), um ein Schadensprofil (11) zu bilden, das insbesondere durch Rutherford-Rückstreuspektrometrie messbar ist, wobei das Profil eine Hauptspitze (12a) von Defekten in einer Tiefe aufweist, die eine vergrabene Sollbruchebene (12) definiert, und eine sekundäre Spitze (13a) von Defekten, die eine oberflächliche beschädigte Schicht (13) definiert,
- Entfernen der oberflächlichen beschädigten Schicht (13) durch chemisches Ätzen und/oder durch mechanisch-chemisches Polieren der Vorderseite (1a) des Donorsubstrats (1), um eine neue Vorderseite (1a') des Donorsubstrats (1) zu bilden,
wobei die vergrabene Sollbruchebene (12) zusammen mit der Vorderseite (1a') des Donorsubstrats (1) die zu übertragende Nutzschicht (10) begrenzt, die eine Dicke zwischen 50 nm und 1400 nm aufweist,
**c)** Zusammenfügen des Donorsubstrats (1) durch molekulare Adhäsion
auf der Vorderflächenseite (1a') mit dem Trägersubstrat (2), um eine geklebte Einheit (50) entlang einer Klebegrenzfläche (51) zu bilden;
**d)** die Trennung entlang der vergrabenen Sollbruchebene (12), was zur Übertragung der Nutzschicht (10) auf das Trägersubstrat (2) führt, um die Halbleiterstruktur (100) zu bilden.

2. Verfahren zur Herstellung nach dem vorstehenden Anspruch, wobei das Entfernen in Schritt b) durch eine Abtragung zwischen 5 nm und 200 nm, bevorzugt zwischen 30 nm und 50 nm umgesetzt wird.

3. Verfahren zur Herstellung nach einem der vorstehenden Ansprüche, wobei das Material des Trägersubstrats (2) monokristallin oder polykristallin ist.

4. Verfahren zur Herstellung nach einem der vorstehenden Ansprüche, wobei die leichten Spezies Wasserstoffionen sind, die mit einer Energie zwischen 30 keV und 210 keV und mit einer Dosis zwischen 1x1016/cm² und 5x10¹⁷/cm² implantiert werden.

5. Verfahren zur Herstellung nach einem der vorstehenden Ansprüche, umfassend einen Schritt e) zur Endbearbeitung, der an der Halbleiterstruktur (100) angewendet wird, die aus Schritt d) hervorgegangen ist, wobei der Schritt e) eine Wärmebehandlung bei einer Temperatur zwischen 1300 °C und 1700 °C einbezieht.

6. Verfahren zur Herstellung nach dem vorstehenden Anspruch, wobei der Schritt e) eine mechanisch-chemische Glättungsbehandlung einer freien Oberfläche (10a) der Nutzschicht (10) umfasst.

7. Verfahren zur Herstellung nach einem der vorstehenden Ansprüche, wobei:
- der Schritt c) das Bilden mindestens einer zusätzlichen Schicht auf der Vorderseite (1a') des Donorsubstrats (1) und/oder auf einer Vorderseite (2a) des Trägersubstrats (2) vor dem Zusammenfügen durch molekulare Adhäsion umfasst; und
- die geklebte Einheit (50), die nach dem Zusammenfügen durch molekulare Adhäsion erhalten wird, die zusätzliche Schicht zwischen dem Donorsubstrat (1) und dem Trägersubstrat (2) umfasst, die an die Klebegrenzfläche (51) angrenzt oder diese letztere einschließt.

8. Verfahren zur Herstellung nach dem vorstehenden Anspruch, wobei die mindestens eine zusätzliche Schicht ein Material umfasst, das aus Silizium, Wolfram, Kohlenstoff und Titan ausgewählt ist.

9. Verfahren zur Herstellung nach einem der vorstehenden Ansprüche, das weiter die Schritte der Bearbeitung mindestens einer mikroelektronischen Hochspannungskomponente auf der Halbleiterstruktur (100) umfasst.

## Claims

1. Method for manufacturing a semiconductor structure (100), comprising the following steps of:
**a)** providing a monocrystalline silicon carbide donor substrate (1) and a silicon carbide carrier substrate (2),
**b)** preparing a useful layer to be transferred, comprising:
- implanting light species in the donor substrate (1) at a front face (1a), so as to form a damage profile (11), in particular measurable by Rutherford backscattering spectroscopy, said profile having a main peak (12a) of deep-level defects defining a buried fragile plane (12) and a secondary peak (13a) of defects defining a superficial damaged layer (13),
- removing the superficial damaged layer (13) by chemical etching and/or by chemical-mechanical polishing of the front face (1a) of the donor substrate (1), to form a new front surface (1a') of the donor substrate (1),
the buried fragile plane (12) delimiting, with the front surface (1a') of the donor substrate (1), the useful layer (10) to be transferred, which has a thickness comprised between 50 nm and 1,400 nm,
**c)** assembling, by molecular bonding, the donor substrate
(1), on the side of the front surface (1a'), and the carrier substrate (2), so as to form an assembly (50) bonded along a bonding interface (51);
**d)** separating along the buried fragile plane (12), leading to the transfer of the useful layer (10) onto the carrier substrate (2), so as to form the semiconductor structure (100).

2. The manufacturing method according to the preceding claim, wherein the removal of step b) amounts to a removal comprised between 5nm and 200nm, preferably comprised between 30nm and 50nm.

3. The manufacturing method according to one of the preceding claims, wherein the material of the carrier substrate (2) is monocrystalline or polycrystalline.

4. The manufacturing method according to one of the preceding claims, wherein the light species are hydrogen ions, implanted with an energy comprised between 30keV and 210keV and with a dose comprised between 1x1016/cm² and 5x10¹⁷/cm².

5. The manufacturing method according to one of the preceding claims, comprising a finishing step e) applied to the semiconductor structure (100) derived from step d), step e) involving a heat treatment at a temperature comprised between 1,300°C and 1,700°C.

6. The manufacturing method according to the preceding claim, wherein step e) comprises a chemical-mechanical smoothing treatment of a free surface (10a) of the useful layer (10).

7. The manufacturing method according to one of the preceding claims, wherein:
- step c) comprises forming at least one additional layer over the front surface (1a') of the donor substrate (1) and/or over a front face (2a) of the carrier substrate (2), prior to assembly by molecular bonding; and
- the bonded assembly (50), obtained after assembly by molecular bonding, comprises the additional layer between the donor substrate (1) and the carrier substrate (2), adjacent to the bonding interface (51) or including the latter.

8. The manufacturing method according to the preceding claim, wherein the -at least one- additional layer comprises a material selected from among silicon, tungsten, carbon, titanium.

9. The manufacturing method according to one of the preceding claims, further comprising steps of elaborating at least one high-voltage microelectronic component on the semiconductor structure (100).
